# EUROPEAN PATENT APPLICATION

(11) **EP 2 541 599 A1**
(43) Date of publication of application: **02.01.2013**
(21) Application number: 11171778.1
(22) Date of filing: 28.06.2011
(51) Int. Cl.: H01L 27/02, G06K 19/073

(54) **Security semiconductor product**

(71) Applicant: NXP B.V., 5656 AG Eindhoven (NL)
(72) Inventor: Garbe, Joachim Christoph Hans, 5656 AG Eindhoven (NL); Ostertun, Sönke, 5656 AG Eindhoven (NL)
(74) Representative: Krott, Michel

(57) **Abstract**

Security semiconductor product with a first light detector, wherein the first light detector comprises a bi-stable circuit, wherein a first state of the bi-stable circuit represents true and a second state of the bi-stable circuit represents false, and in that the bi-stable circuit comprises an asymmetry to cause the bi-stable circuit to adopt true when having been subjected to a light pulse.

## Description

### FIELD OF THE INVENTION

The invention as described hereinafter relates to security semiconductor products.

Many semiconductor products contain important data which have to be kept secret, like codes for encryption or identification. Examples are chips in banking cards, for ticketing or pay TV applications. Security semiconductor products which are used in such fields have to be security certified to prove a certain security standard. Sufficient resistance against all kinds of attacks which aim at retrieval of codes or uncontrolled change of functionality has to be implemented.

One form of attack is fault injection where the functionality of the security semiconductor product is disturbed or changed by physical influences from the outside. This can have many different forms.

A prominent attack form is to use short strong light pulses. Sophisticated equipment is available, where short strong laser pulses can be focused on very small areas, can be synchronized with clocks or other electrical timing signals, and where two or even more independent light pulses can be used on different areas. Such attack forms are both used on the front side of the security semiconductor product or on the backside of the security semiconductor product after thinning of the device.

It is known that bi-stable circuits, e.g. latches and flip-flops, used in security semiconductor products can change their state by strong light pulses due to induced high leakage current. Thus, these pulses can be used to disturb the normal functionality. Bi-stable circuits are used in the logic part of the security semiconductor product which makes up the CPU, co-processors for data encryption, interfaces and other. Accordingly, especially the bi-stable circuits have to be protected from light pulses.

One of the countermeasures is to use light detectors which may detect such a light pulse, in which case the chip is put into a defined safe state like a complete reset.

The currently used light detectors are made of a large regular junction with an analogue detection circuit attached. The layout of such light detectors looks very differently compared to the bi-stable circuits used within the logic area. With up-to-date tools high-resolution optical or infrared microscope pictures from the frontside or the backside of a security semiconductor product can be taken where the position of light detectors in the logic area can be seen. Thus, these areas can easily be avoided during an attack.

It is therefore an object of the current invention to provide a security semiconductor product with a light detector, which can be used to detect light attacks, in particular on the logic part of the security semiconductor product, and which is not easily recognizable, and a corresponding method for producing such a security semiconductor product.

### SUMMARY OF THE INVENTION

This object has been solved by the subject matter according to the independent claims. Advantageous embodiments of the present invention are described by the dependent claims.

According to a first aspect of the invention there is provided a security semiconductor product with a first light detector, characterized in that the first light detector comprises a bi-stable circuit, wherein a first state of the bi-stable circuit represents true and a second state of the bi-stable circuit represents false, and in the bi-stable circuit comprises an asymmetry to cause the bi-stable circuit to adopt true when having been subj ected to a light pulse.

The light detectors of the security semiconductor product according to the invention may require less space than conventional light detectors. Accordingly, more of them may be included in an inventive security semiconductor product without increasing the die size. This may for given costs provide a better protection for the security semiconductor product. When attackers scan the complete security semiconductor device with light and note the places where a reset occurs, they may no longer be able to avoid these areas in following attacks. Alternatively or in addition, a smaller die may be used for the security semiconductor product which may reduce manufacturing costs. Furthermore, the light detectors may be provided within the logic part of the security semiconductor product.

According to a first advantageous embodiment of the security semiconductor product, the bi-stable circuit comprises a first transistor and a differing second transistor to cause the asymmetry.

Differing transistors may easily be provided in the logic areas of security semiconductor products. For example, dimensions of transistors may be changed by differing masks or the electrical behaviour may be influenced by differing doping amounts. In particular, these additional steps may necessitate only small changes to the manufacturing process and may be implemented in conventional planar metal oxide semiconductor technique.

According to a second advantageous embodiment of the security semiconductor product, the second transistor comprises a differing transistor width and/or a differing transistor length and/or a differing transistor junction area and/or a differing distance to a next well contact.

Increasing the transistor width may be an easy way to augment the leakage current. Changing the transistor length may on the other hand influence the response time of a transistor and therefore lead to an asymmetric behaviour. Differing transistor junction areas and/or differing distances to next well contacts may provide alternative way to achieve an asymmetry. These measures may be combined to optimize the total area necessary for a light detector according to the invention.

According to another advantageous embodiment the first light detector further comprises a light shield and/or a light reflector to cause the asymmetry.

Light shields and/or light reflectors may ensure an asymmetry without changing the electrical characteristics of the bi-stable circuit. These may remain symmetric so that the bi-stable circuit may be used as a normal logic node when a protection against light attacks is not necessary. Light shield and/or light reflectors may easily be provided in that the metal interconnection layers of the security semiconductor products are dimensioned accordingly.

According to a further advantageous embodiment the first light detector further comprises a first input configured to reset the bi-stable circuit to false.

This input may allow multiple use of the first light detector. A certain time after a light attack the bi-stable circuit may of the security semiconductor product may be reset and the security semiconductor product may go back to normal operation.

According to a still further advantageous embodiment the first light detector comprises a second input configured to set the bi-stable circuit to true.

In this way the following signal processing may be tested if it performs correctly when a light attack has taken place. Furthermore, a second input configured to set the bi-stable circuit to true may provide the possibility to use the first light detector as conventional logic node when no light detection is necessary.

According to another advantageous embodiment the security semiconductor product comprises a second light detector differing from the first light detector.

Differing light detectors may be used to enhance the security of security semiconductor products. For example, differing light detectors may hinder pattern recognition. Furthermore differing light detectors may provide a non-deterministic behaviour for concurring light attacks.

According to a second aspect of the invention there is provided a method for producing a security semiconductor product comprising an asymmetric bi-stable circuit. In particular, there is provided a method for producing a security semiconductor product as described hereinbefore.

### BRIEF DESCRIPTION OF THE DRAWING

Figure 1 shows a first bi-stable circuit usable in a security semiconductor product according to the invention.
Figure 2 shows a second bi-stable circuit usable in a security semiconductor product according to the invention.
Figure 3 shows a third bi-stable circuit usable in a security semiconductor product according to the invention.
Figure 4 shows the schematics of the bi-stable circuit shown in Figure 3
Figure 5 shows the layout of the bi-stable circuit shown in Figure 3 and Figure 4

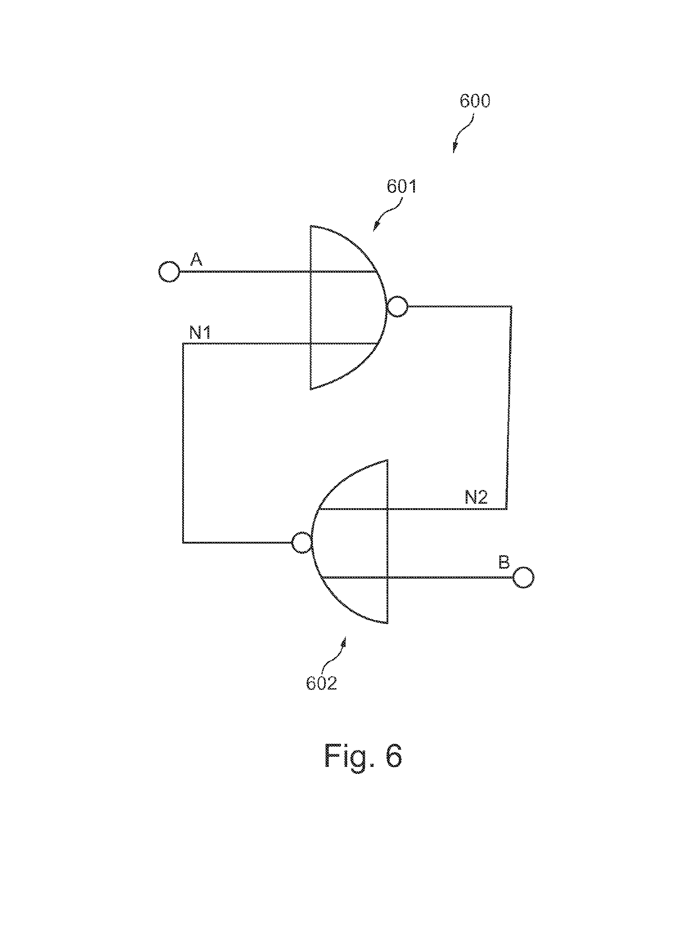

Figure 6 shows a further bi-stable circuit usable in a security semiconductor product according to the invention.

### DETAILED DESCRIPTION

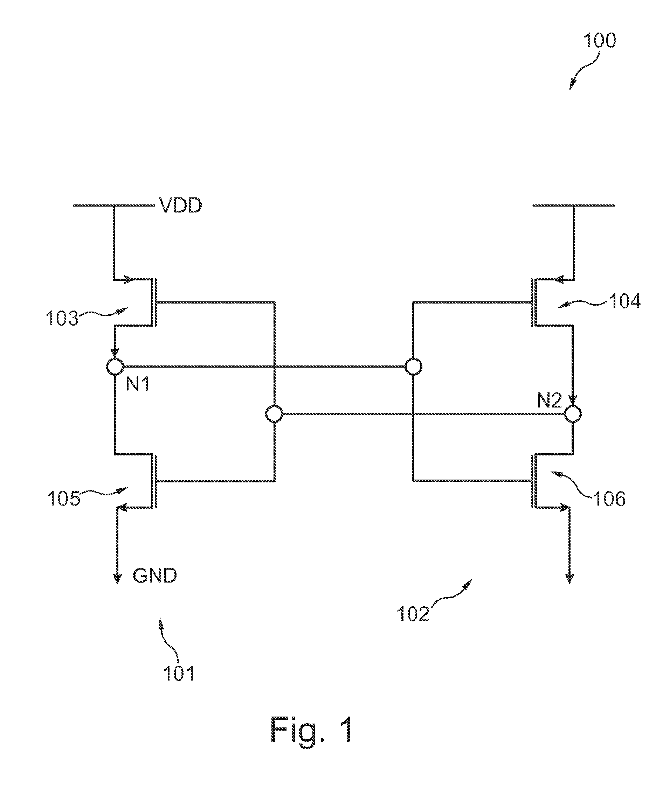

Figure 1 shows a simple latch 100 using two inverters 101, 102. The stable situations are either N1 at VDD potential and N2 at GND, or the opposite, N1 at GND and N2 at VDD. When subjected to strong incident light, the junctions of the pmos transistors 103, 104 may leak towards the nwell underneath which is at VDD potential, the junctions of the nmos transistors 105, 106 may leak towards the p-type substrate (at GND potential). At the same time the nwell itself would also show leakage towards the substrate. Locally the nwell potential as well as all junction potentials would drop towards GND, but normally not completely. The amount of the voltage drop depends inter alia on the size of the junctions, on the light intensity, on the distance to well or substrate contacts.

After the light pulse has ended the nwell and substrate contacts will force all junctions connected directly to VDD or GND back to their normal values (VDD or GND). Other nodes will also be defined again. The levels of nodes N1 and N2 will both be at a potential between VDD and GND during the pulse.

The two inverters 101, 102 have the same layout with respect to wells, active area, and gates. However, the metal connection is asymmetric. Incident light from the backside may partly be reflected back to the junction and increase the leakage current in inverter 102. Accordingly, N1 will preferably go to VDD and in this example represent true.

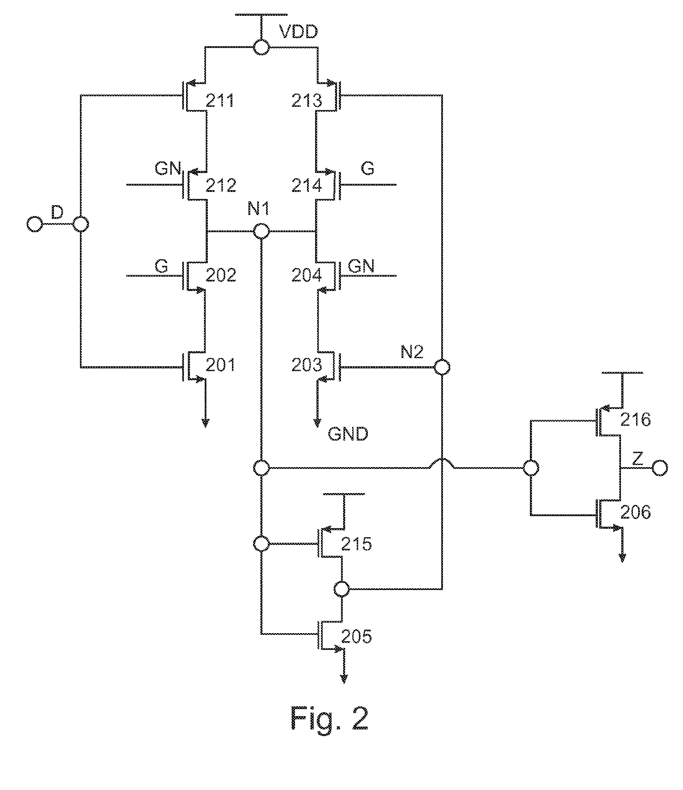

Figure 2 shows another latch 200 comprising a nmos transistors 201, 202, 203, 204, 205, 206 and pmos transistors 211, 212, 213, 214, 215, 216. N1 and N2 can be defined when G is at VDD level (which implies that GN is at GND level). N1 then becomes D, and N2 is D inverted. Z is again equal to D and may be used as an output signal.

The transistors on the left 201, 202, 211, 212 are designed larger than the transistors on the right 203, 204, 213, 214. For example, the pmos transistors 211, 212 have a transistor width of 0,68 µm and the pmos transistors 213, 214 have a transistor width of 0.20 µm. This results in a larger leakage at the junctions belonging to transistors 211 and 212 under light incidence. Hence, after recovery from the light incidence the probability of a resulting node N1 at VDD is higher then at GND. N1 at VDD thus represents the true state of the bi-stable circuit.

The asymmetry thus allows using such a latch 200 as a sensor for light attacks. The incident light generally must be intensive enough to change a bi-stable circuit so much that following bi-stable circuits will have a different potential at least on one node. Otherwise the functionality is not changed. However, even though not explicitly further detailed incident light might also lead to small timing changes in bi-stable circuits comprising an asymmetry and can lead to a functionality change.

If the incident light is strong enough to change the functionality of a bi-stable circuit comprising an asymmetry it can be assumed that it is also sufficient to change the state of bi-stable circuit in the logic area.

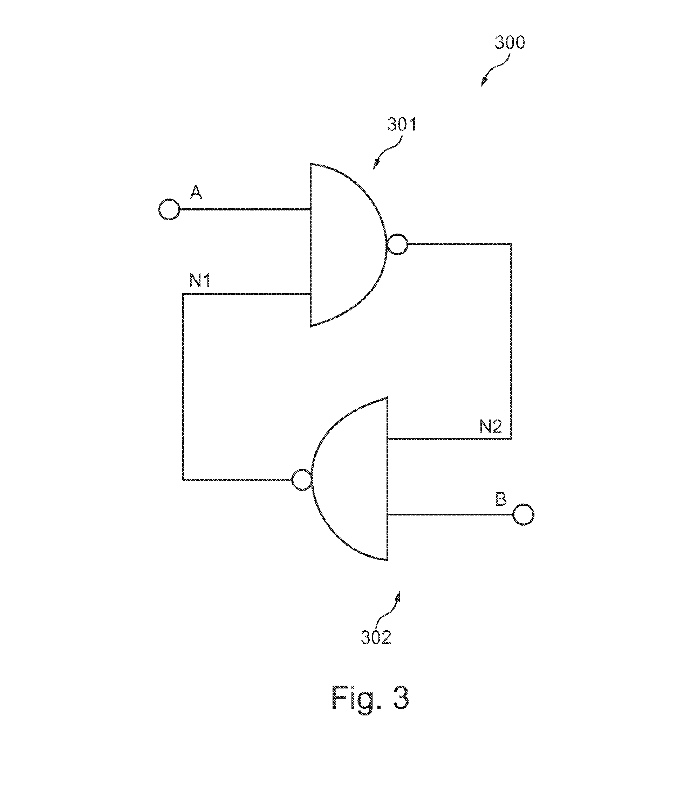

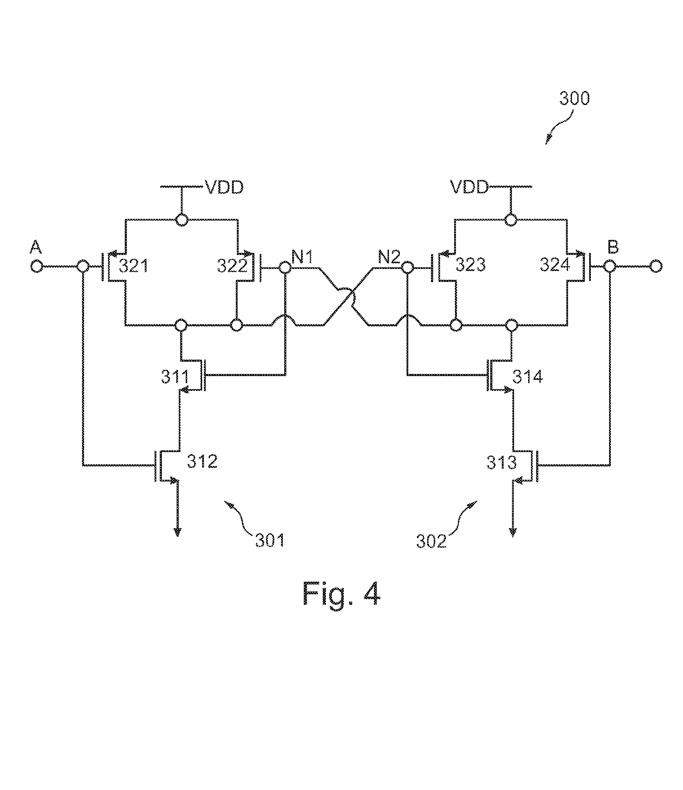

Figure 3 shows an example of a further bi-stable circuit 300. The bi-stable circuit 300 comprises a first NAND gate 301 and a second NAND gate 302. The schematics of this bi-stable circuit 300 can be seen in Figure 4. The first NAND gate 301 comprises nmos transistors 311, 312 and pmos transistors 321, 322. The second NAND gate 302 comprises nmos transistors 313, 314 and pmos transistors 323, 324. In a stable situation the input A and the input B will be at VDD level. A pulse to GND at input A will force N2 to VDD. If input B stays at VDD, then N1 will be forced to GND by the second NAND gate 302. A pulse to GND at input B will result in the opposite situation. In this way such a bi-stable circuit 300 can be set to any required state. If used as a light sensor, the circuit will be preset to the state opposite to the one expected after a light pulse.

Input A therefore may be used as an input to set the bi-stable circuit 300 to false. That is to say, to arm the bi-stable circuit 300 to detect a light pulse or to reset the bi-stable circuit 300 after a light pulse has been detected. Input B may be used as an input to set the bi-stable circuit 300 to true. Accordingly, the signal processing after the light detector may be tested. Furthermore, the bi-stable circuit 300 may be used as a normal logic node when light pulse detection is not necessary.

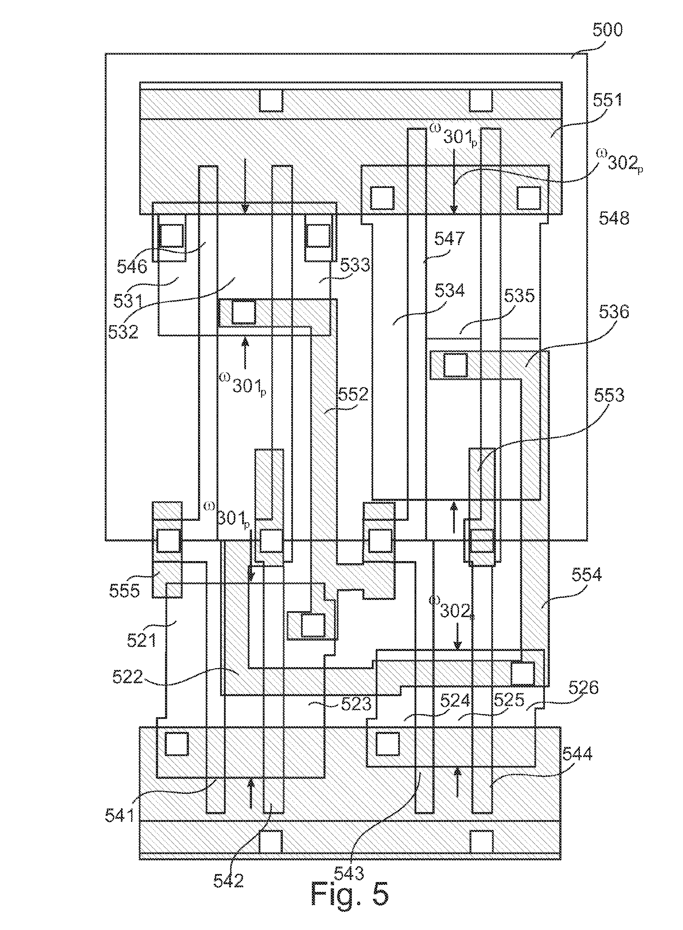

Figure 5 illustrates an exemplary layout of the bi-stable circuit 300. For illustrative purposes only the nwell 500, the active areas 531, 532, 533, 534, 535, 536 for the pmos transistors 321, 322, 323, 324, the active areas 521,522, 523, 524, 525, 526 for the nmos transistors 311, 312, 313, 314, the polysilicon gates 541, 542, 543, 544, 545, 546, 547, 548, the lowest metal layer 551, 552, 553,554, 555, and the contacts (black squares) are shown. The left side corresponds to the NAND gate 301 and the right side to the NAND gate 302. The transistor width W₃₀₁ₚ of the pmos transistors 321 and 322 is smaller than the corresponding transistor width W₃₀₂ₚ of the pmos transistors 323 and 324. On the other hand the transistor width W₃₀₁ₙ of the nmos transistors 311 and 312 is larger than the transistor width W₃₀₂ₙ of the nmos transistors 313 and 314. This will result in larger leakage towards GND in the nmos transistors 311 and 312 than in the nmos transistors 313 and 313, and larger leakage of the pmos transistors 323 and 324 towards VDD than of the pmos transistors 321 and 322. As a result the output N2 of the NAND gate 301 should rather go to GND after a light pulse, and the output N1 of the NAND gate 302 to VDD.

The same principle can be used for a bi-stable circuit 600 comprising a NOR gate 601 and a NOR gate 602.

For very critical registers - which are also bi-stable circuits - meaning those that contain very critical data like keys, it is easily possible to integrate the bi-stable circuits comprising an asymmetry as described hereinbefore. For example, the light detectors could be placed in the centre of the register containing this critical information to protect it. The increase in, for example, one third of the area for this register may be easily tolerable if a strong security enhancement is reached.

## Claims

1. Security semiconductor product with a first light detector,
wherein the first light detector comprises a bi-stable circuit (100,300),
wherein a first state of the bi-stable circuit represents true and a second state of the bi-stable circuit represents false, and
wherein the bi-stable circuit comprises an asymmetry to cause the bi-stable circuit to adopt true when having been subjected to a light pulse.

2. Security semiconductor product according to claim 1,
wherein the bi-stable circuit (300) comprises a first transistor (321, 322, 311, 312) and a differing second transistor (323, 324, 313, 314) to cause the asymmetry.

3. Security semiconductor product according to claim 2,
wherein the second transistor (323, 324, 313,314) comprises a differing transistor width and/or a differing transistor length and/or a differing transistor junction area and/or a differing distance to a next well contact compared to the first transistor (321, 322, 311, 312).

4. Security semiconductor product according to any one of claims 1,
wherein the first light detector (100) further comprises a light shield and/or a light reflector to cause the asymmetry.

5. Security semiconductor product according to any one of claims 1,
wherein the first light detector further comprises a first input configured to reset the bi-stable circuit to false.

6. Security semiconductor product according to claim 1,
wherein the first light detector comprises a second input configured to set the bi-stable circuit to true.

7. Security semiconductor product according to claim 1,
wherein the security semiconductor product comprises a second light detector differing from the first light detector.

8. Method for producing a security semiconductor product according to claim 1 with an asymmetric bi-stable circuit.
